# EUROPEAN PATENT SPECIFICATION

(11) **EP 4 372 807 B1**
(45) Date of publication and mention of the grant of the patent: **16.10.2024**
(21) Application number: 22207915.4
(22) Date of filing: 16.11.2022
(51) Int. Cl.: H01L 23/48, H01L 25/07, H01L 21/48, H01L 23/31, H01L 23/053, H01L 23/24, H01L 23/49, H01L 23/373, H01L 23/498

(54) **SUBSTRATE ARRANGEMENT AND METHODS FOR PRODUCING A SUBSTRATE ARRANGEMENT**
SUBSTRATANORDNUNG UND VERFAHREN ZUR HERSTELLUNG EINER SUBSTRATANORDNUNG
AGENCEMENT D'UN SUBSTRAT ET PROCÉDÉS DE PRODUCTION D'UN AGENCEMENT D'UN SUBSTRAT

(43) Date of publication of application: 22.05.2024
(73) Proprietor: Infineon Technologies AG, 85579 Neubiberg (DE)
(72) Inventor: BAYER, Christoph, 97320 Albertshofen (DE); FUEGL, Michael, 92318 Neumarkt (DE); SINGER, Frank, 93128 Regenstauf (DE); MEYER, Thorsten, 93053 Regensburg (DE); CRAES, Fabian, 59494 Soest (DE); GRASSMANN, Andreas, 93049 Regensburg (DE); OTTO, Frederik, 45659 Recklinghausen (DE)
(74) Representative: Westphal, Mussgnug & Partner, Patentanwälte mbB

(56) References cited:
- US-A1- 2006 113 656
- US-A1- 2010 261 343
- US-A1- 2020 321 302

## Description

### TECHNICAL FIELD

The instant disclosure relates to a substrate arrangement, in particular to a substrate arrangement for a power semiconductor module arrangement, and to methods for producing such a substrate arrangement.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate or heat sink.

There is a need for a substrate arrangement that allows to securely mount elements thereon in a simple manner.

### SUMMARY

A substrate arrangement comprises a first metallization layer, a plurality of nanowires arranged on a surface of the first metallization layer, and at least one component arranged on the first metallization layer such that a first subset of the plurality of nanowires is arranged between the first metallization layer and the at least one component, wherein the plurality of nanowires is evenly distributed over a section such a manner that the conductive nanotubes fixed to the electrodes remain on the electrodes formed on the semiconductor substrate.

Document US 2006/113656 A1 discloses a composite conductive film that is formed of a polymer-matrix and a plurality of nano-sized conductive lines. The composite conductive film has low resistance, to connect between a fine-pitch chip and a chip in a low temperature and low pressure condition. The conductive lines are parally arranged and spaced apart from each other, to provide anisotropic conductivity. The conductive film can be served as an electrical connection between a fine-pitch chip and a chip or a fine-pitch chip and a substrate.

There is a need for a substrate arrangement that allows to securely mount elements thereon in a simple manner.

### SUMMARY

A substrate arrangement comprises a first metallization layer, a plurality of nanowires arranged on a surface of the first metallization layer, and at least one component arranged on the first metallization layer such that a first subset of the plurality of nanowires is arranged between the first metallization layer and the at least one component, wherein the plurality of nanowires is evenly distributed over a section of the surface area or over the entire surface area of the first metallization layer, each of the plurality of nanowires includes a first end and a second end, wherein the first end of each of the plurality nanowires is inseparably connected to the surface of the first metallization layer, the second end of each nanowire of the first subset is inseparably connected to a surface of one of the at least one component such that the first subset of nanowires forms a permanent connection between the first metallization layer and the at least one component, the at least one component comprises at least one semiconductor body, and the number of nanowires comprised in the first subset of nanowires is less than the number of nanowires comprised in the plurality of nanowires. The substrate arrangement further includes an encapsulant, wherein the encapsulant consists of or includes a silicone gel and directly adjoins the second ends of a second subset of the plurality of nanowires and fills any gaps and spaces between the nanowires of the second subset.

A method includes forming a first metallization layer, forming a plurality of nanowires on a surface of the first metallization layer, and arranging at least one component on the first metallization layer such that a first subset of the plurality of nanowires is arranged between the first metallization layer and the at least one component, wherein the plurality of nanowires is evenly distributed over a section of the surface area or over the entire surface area of the first metallization layer, each of the plurality of nanowires includes a first end and a second end, wherein the first end of each of the plurality nanowires is inseparably connected to the surface of the first metallization layer, the second end of each nanowire of the first subset is inseparably connected to a surface of one of the at least one component such that the first subset of nanowires forms a permanent connection between the first metallization layer and the at least one component, the at least one component comprises at least one semiconductor body, and the number of nanowires comprised in the first subset of nanowires is less than the number of nanowires comprised in the plurality of nanowires. The method further includes forming an encapsulant, wherein the encapsulant consists of or includes a silicone gel and directly adjoins the second ends of a second subset of the plurality of nanowires and fills any gaps and spaces between the nanowires of the second subset.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2, including Figures 2A and 2B, schematically illustrates a method for attaching two connection partners to each other.
Figure 3, including Figures 3A and 3B, schematically illustrates another method for attaching two connection partners to each other.
Figure 4 is a cross-sectional view of a substrate arrangement according to one example.
Figure 5, including Figure 5A to 5C, schematically illustrates a method for forming a substrate arrangement according to one example.
Figure 6, including Figures 6A to 6C, schematically illustrates a method for forming a substrate arrangement according to another example.
Figure 7, including Figures 7A to 7D, schematically illustrates a method for forming a substrate arrangement according to an even further example.
Figure 8 is a cross-sectional view of a substrate arrangement according to another example.
Figure 9 is a cross-sectional view of a substrate arrangement according to one example with an encapsulant arranged thereon.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

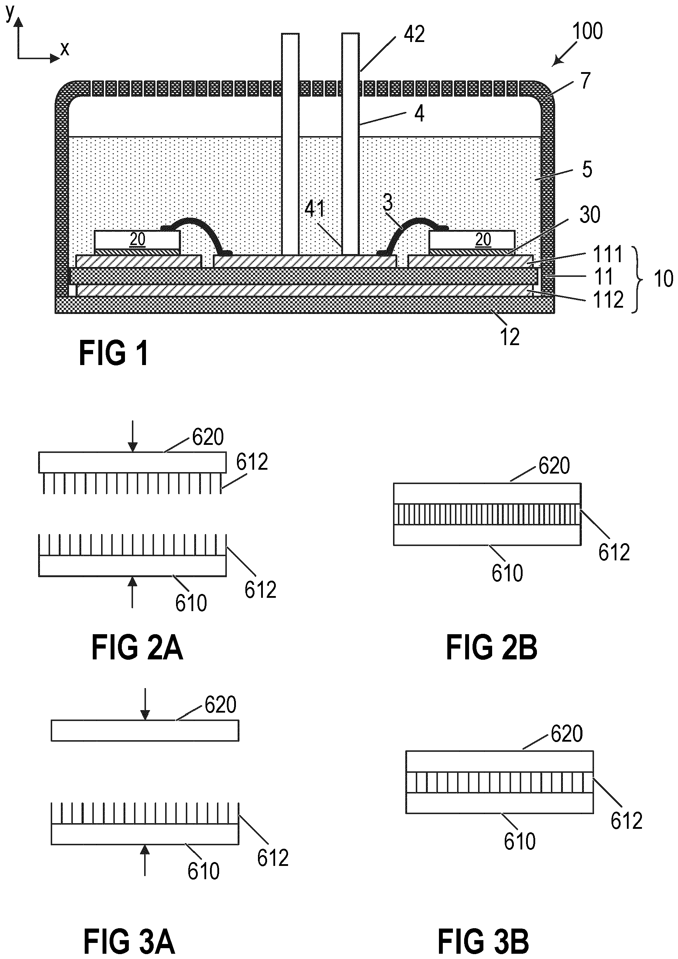

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover or lid. This is, however, only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. It is, however, also possible that the power semiconductor module arrangement 100 does not comprise a base plate 12 at all. For example, the substrate 10 may form a ground surface of the housing 7 instead. It is also possible that the housing 7 comprises a ground surface, sidewalls and a cover, and one or more substrates 10 are arranged on the ground surface and inside the housing 7. That is, the power semiconductor module arrangement may be an arrangement comprising a base plate 12, or a base plate-less power semiconductor module arrangement 100.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. For example, the second ends 42 of the terminal elements 4 may be connected to a printed circuit board that is arranged outside of the housing 7 (not illustrated in Figure 1).

The power semiconductor module arrangement 100 further includes an encapsulant 5. The encapsulant 5 consists of or includes a silicone gel for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

As has been described above, different components (e.g., semiconductor bodies 20, terminal elements 4 or any other components) may be mounted to the substrate 10 (i.e. the first metallization layer 111) by means of an electrically conductive connection layer 30. Such an electrically conductive connection layer 30, however, may have several drawbacks. For example, a plurality of different steps may have to be performed when forming an electrically conductive connection layer 30 (e.g., solder layer, a layer of an electrically conductive adhesive, or a layer of a sintered metal powder).

Now referring to Figure 2, a first connection partner 610 and a second connection partner 620 are schematically illustrated. The first connection partner 610 may be a substrate for a power semiconductor module, for example. The second connection partner 620 may be a semiconductor body, a terminal element, or any other component that is to be mounted to the substrate, for example. It is, however, also possible that the first connection partner 610 is a heat sink or base plate, and the second connection partner 620 is a substrate. A plurality of nanowires 612 is formed on a surface of the first connection partner 610 which faces the second connection partner 620. A second plurality of nanowires 612 is formed on a surface of the second connection partner 620 which faces the first connection partner 610. Each of the plurality of nanowires 612 has a first end and a second end. A first end of each of the plurality of nanowires 612 is inseparably connected to the surface of the first connection partner 610. A first end of each of the second plurality of nanowires 612 is inseparably connected to the surface of the second connection partner. The first and second connection partners 610, 620 are arranged at a certain distance from each other. The second ends of the plurality of nanowires 612 and the second ends of the second plurality of nanowires 612 are free ends. The surface of the first connection partner 610 on which the plurality of nanowires 612 is formed and the surface of the second connection partner 620 on which the second plurality of nanowires 612 is formed may consist of the same material such as, e.g., Al, an Al alloy, Cu, a Cu alloy, Ag, an Ag alloy, Au, or an Au alloy.

The first connection partner 610 and the second connection partner 620 are then moved towards each other such that the second ends of the plurality of nanowires 612 contact the surface of the second connection partner 620, and the second ends of the second plurality of nanowires 612 contact the surface of the first connection partner 610. Under the influence of pressure and heat, the second ends of the plurality of nanowires 612 may be inseparably connected to the surface of the second connection partner 620, and the second ends of the second plurality of nanowires 612 may be inseparably connected to the surface of the first connection partner 610. In this way, a permanent connection between the first connection partner 610 and the second connection partner 620 may be formed by means of the nanowires 612.

The term nanowires 612 as used herein designates any element having the form of a wire, i.e. a length that is several times larger than its diameter, wherein the dimensions of the element are in the nanometer range. For example, so-called nanotubes or nanorods may also be used and are considered to fall under the term nanowire as used herein. Generally speaking, a nanowire 612 is a nanostructure in the form of a wire having a nanorange diameter. For example, a diameter of a nanowire 612 may be between 500nm and 1200nm. The nanowires 612 may have a length between their first end and their second end of between 10µm and 70µm, for example. The nanowires 612 generally extend perpendicular to the surface on which they are formed. Therefore, all nanowires 612 may have the same length such that the second ends of all of the nanowires 612 extend all the way to the surface of the other connection partner. The nanowires 612 may comprise or consist of carbon, cobalt, copper, silicon, or gold, for example.

Nanowires 612 may be formed by any suitable process such as, e.g., (chemical) vapor deposition, suspension, electrochemical deposition, VLS growth (VLS = Vapor-liquid-solid method), and ion track technology.

In the example illustrated in Figure 2, the first and the second connection partners 610, 620 are each provided with nanowires 612. This, however, is only an example. As is schematically illustrated in Figure 3A, it is also possible to form nanowires 612 only on one of the two connection partners. In the example illustrated in Figure 2B, the plurality of nanowires 612 formed on the first connection partner 610 and the second plurality of nanowires 612 formed on the second connection partner 620 can be considered to intertwine when the first and second connection partner 610, 620 are arranged close enough to each other and a permanent connection is formed between the two connection partners 610, 620. This is not the case in the example of Figure 3B, because no nanowires 612 are formed on the surface of the second connection partner 620. However, with the plurality of nanowires 612 formed on the first connection partner 610, it is still possible to form a permanent connection between the first connection partner 610 and the second connection partner 620. The stability of the connection, however, may be further improved if nanowires 612 are provided on both surfaces.

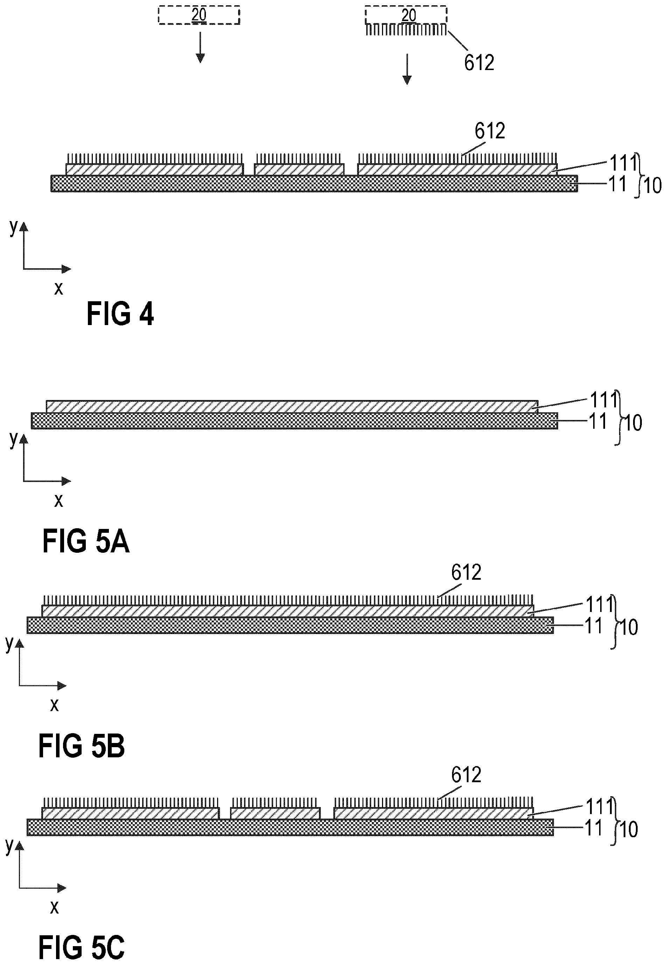

Now referring to Figure 4, a substrate arrangement according to one example is schematically illustrated. The substrate arrangement may comprise a substrate 10, similar to what has been described with respect to Figure 1 above. The dielectric insulation layer 11, however, may also be omitted. The metallization layer 111, for example, may also be a so-called lead frame (die pad). That is, the substrate arrangement may solely comprise a metallization layer 111 and no dielectric insulation layer 11. The substrate 10 that is schematically illustrated in Figure 4 comprises a dielectric insulation layer 11 and a first metallization layer 111 attached to a first side of the dielectric insulation layer 11. The substrate 10, optionally, may further comprise a second metallization layer (not specifically illustrated in Figure 4). The substrate arrangement further comprises a plurality of nanowires 612 arranged on a surface of the first metallization layer 111. If the metallization layer 111 is arranged on a dielectric insulation layer 11, the plurality of nanowires 612 is arranged on a surface of the first metallization layer 111 that faces away from the dielectric insulation layer 11. The plurality of nanowires 612 is evenly distributed over a section of the surface area or over the entire surface area of the first metallization layer 111. That is, the number of nanowires 612 per unit area is the same over at least a section of the entire surface area of the first metallization layer 111. According to one example, the section of the surface area of the first metallization layer 111 covered by the plurality of nanowires 612 is between 60% and 100%, or between 70% and 100% of the entire surface area of the first metallization layer 111. In the example illustrated in Figure 4, the first metallization layer 111 is a structured layer. All of the different sections of the first metallization layer 111 may be entirely covered by nanowires 612. It is, however, also possible that one or more, but not all sections of the first metallization layer 111 remain free of nanowires 612. Additionally or alternatively it is also possible that one or more sections are only partly covered by nanowires 612.

The nanowires 612 are generally formed on the first metallization layer 111 before any components (e.g., semiconductor bodies 20, terminal elements 4, or any other components) are arranged on the substrate 10. By covering at least a (large) section or even the entire surface area of the first metallization layer 111 with nanowires 612, the substrate 10 may be equipped with components very flexibly. The section that is covered by the nanowires 612 is larger than the area required for mounting the components 20, 4 to the metallization layer 111. In this way, the components that are to be arranged on the substrate 10 do not have to be mounted to any specifically dedicated areas. That is, the substrate arrangement can be sold to different customers, irrespective of the specific design of the customer. Or the same customer may use the same substrate for different designs without the need for any adaptions or customizations. After any semiconductor bodies 20 and/or other components have been mounted to the substrate 10, a different subset of the plurality of nanowires 612 is arranged between each of the at least one component 20, 4 and the first metallization layer 111, wherein the second end of each nanowire 612 of the at least one subset is inseparably connected to a surface of the respective component 20, 4 such that each subset of nanowires 612 forms a permanent connection between the respective component 20, 4 and the first metallization layer 111.

The number of nanowires 612 comprised in the at least one subset of nanowires 612, however, is less than the number of nanowires 612 comprised in the plurality of nanowires 612. That is, the second ends of at least one other subset of nanowires 612 are free ends that are not connected to any component 20, 4.

A method for producing a substrate arrangement according to one example comprises forming a first metallization layer 111, forming a plurality of nanowires 612 on a surface of the first metallization layer 111, and arranging at least one component 20, 4 on the first metallization layer 111 such that a first subset of the plurality of nanowires is arranged between the first metallization layer and the at least one component, wherein the plurality of nanowires 612 is evenly distributed over a section of the surface area or over the entire surface area of the first metallization layer 111, each of the plurality of nanowires 612 comprises a first end and a second end, wherein the first end of each of the plurality nanowires 612 is inseparably connected to the surface of the first metallization layer 111, the second end of each nanowire of the first subset is inseparably connected to a surface of one of the at least one component 20, 4 such that the first subset of nanowires forms a permanent connection between the first metallization layer 111 and the at least one component 20, 4, the at least one component comprises at least one semiconductor body 20, and the number of nanowires 612 comprised in the first subset of nanowires 612 is less than the number of nanowires 612 comprised in the plurality of nanowires 612.

In the example illustrated in Figure 5, a substrate 10 comprising a dielectric insulation layer 11 and a continuous first metallization layer 111 is provided (Figure 5A), and the plurality of nanowires 612 is formed on the continuous first metallization layer 111 (Figure 5B). The first metallization layer 111 in this example is only structured after forming the plurality of nanowires 612, as is schematically illustrated in Figure 5C.

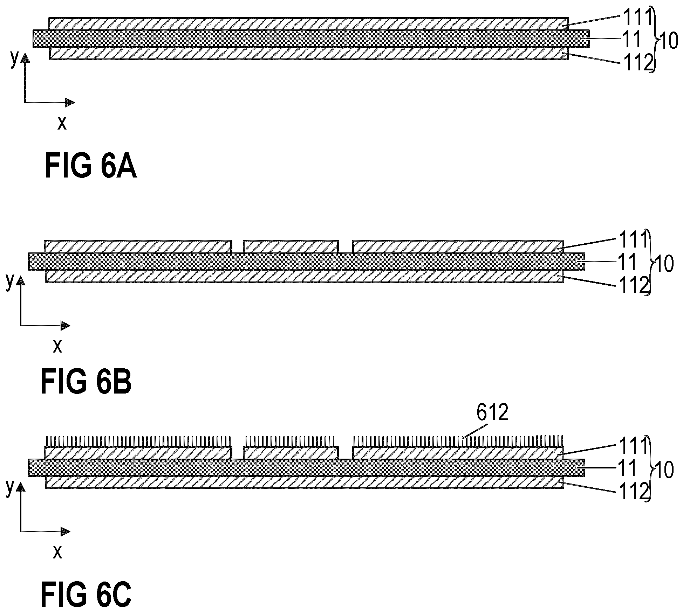

According to another example, however, and as is schematically illustrated in Figure 6, it is alternatively also possible to provide a substrate 10 comprising a dielectric insulation layer 11 and a continuous first metallization layer 111 (Figure 6A), and to structure the first metallization layer 111 (Figure 6B) before forming the plurality of nanowires 612 (Figure 6C). When structuring the first metallization layer 111, two or more separate sections and recesses between different sections of the first metallization layer 111 are formed.

As has been described above, different methods can be used to form the nanowires 612. With most methods, nanowires 612 can only be formed on metallic surfaces. Therefore, if the first metallization layer 111 is structured first, as is exemplarily illustrated in Figure 6, generally no nanowires 612 will form on those sections of the dielectric insulation layer 11, which are no longer covered by the first metallization layer 111. As has been described with respect to Figure 1 above, the dielectric insulation layer 11 generally does not comprise any metallic surfaces. Therefore, no nanowires 612 will grow on the surfaces of the dielectric insulation layer 11.

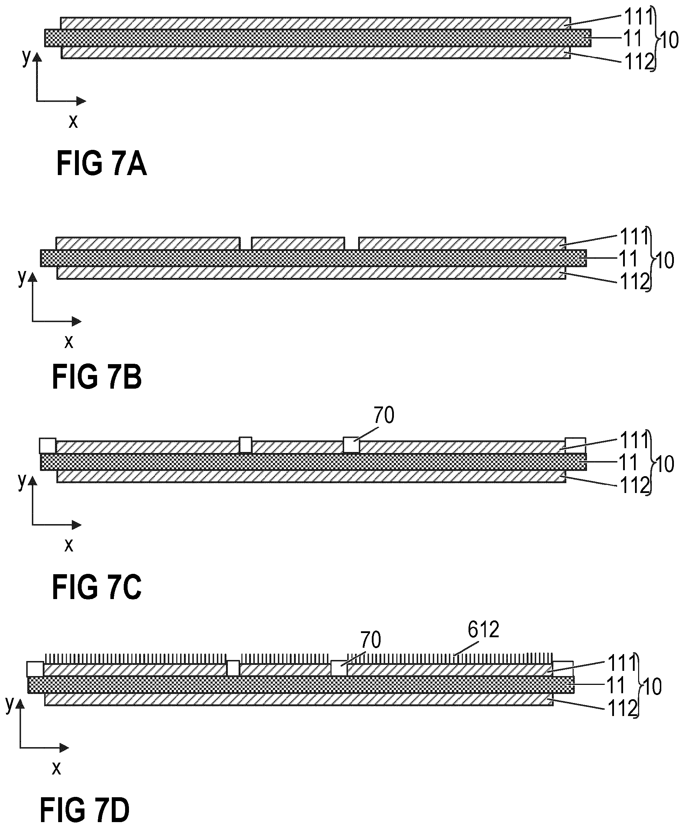

According to another example, however, it is also possible to form a masking layer 70 after structuring the first metallization layer (see Figure 7B) and before forming the plurality of nanowires 612, as is schematically illustrated in Figure 7C. In particular, the masking layer 70 may be formed on those sections of the dielectric insulation layer 11 that are not covered by the first metallization layer 111, thereby preventing nanowires 612 from being formed on the dielectric insulation layer 11. Once the nanowires 612 have been formed, the masking layer 70 may be removed (not specifically illustrated).

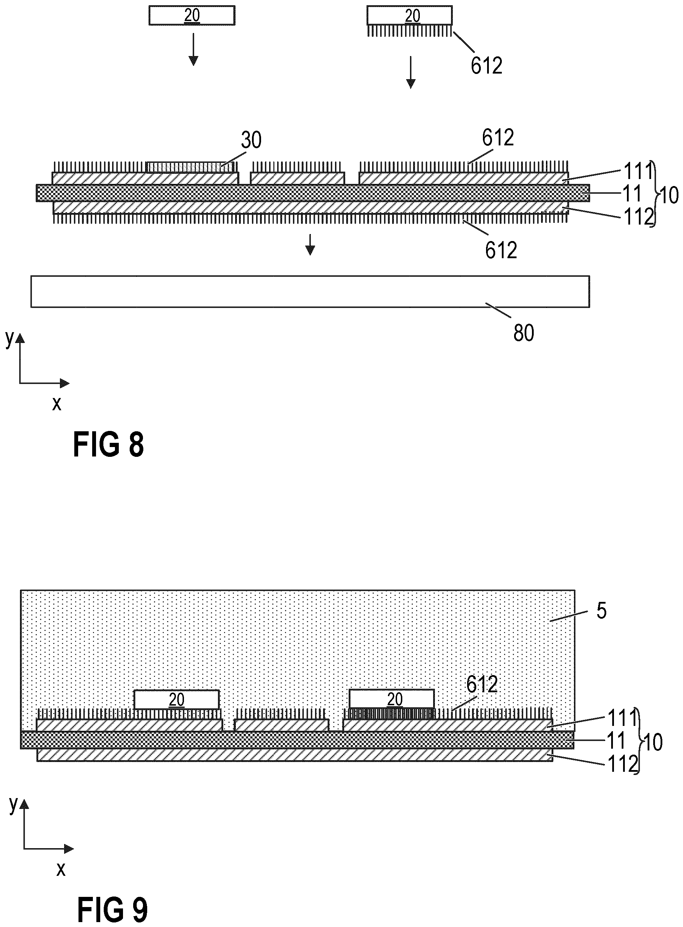

Now referring to Figure 8, components such as, e.g., semiconductor bodies 20, may be mounted on the surface of the first metallization layer 111. Such components 20 may be fitted with nanowires 612 as well, as has been described with respect to Figure 2 above and as is exemplarily illustrated for the semiconductor body on the right hand side of Figure 8. This, however, is not mandatory. As has been described with respect to Figure 3 above and as is exemplarily illustrated on the left hand side of Figure 8, it is also possible that no nanowires 612 are formed on a surface of the component that is to be mounted to the substrate 10. As has been described with respect to Figures 2 and 3 above, the components may be mounted to the substrate 10 under the influence of heat and pressure. No additional solder pastes or sinter pastes are generally required. However, it is also possible to form an additional electrically conductive connection layer 30 between one or more of the components 20, 4 and the first metallization layer 111, similar to what has been described with respect to Figure 1 above and as is schematically illustrated for the semiconductor body 20 on the left hand side of Figure 8. Such an electrically conductive connection layer 30 may be formed only regionally. In particular, electrically conductive connection layers 30 may only be formed in those areas that are arranged between the first metallization layer 111 and one of the components 20, 4 mounted thereon. The material of the electrically conductive connection layer 30 fills any gaps or spaces between the respective ones of the nanowires 612 and may even further increase the strength of the connection formed between the first metallization layer 111 and the respective component 20, 4. This, however, is only optional. The strength of the connection is generally sufficient even without an additional electrically conductive connection layer 30.

Optionally, as is schematically illustrated in Figure 8, the substrate arrangement may further comprise a second metallization layer 112 attached to a second side of the dielectric insulation layer 11 opposite the first side, and a second plurality of nanowires 612 arranged on a surface of the second metallization layer 112 that faces away from the dielectric insulation layer 11, wherein the second plurality of nanowires 612 is evenly distributed over the entire surface of the second metallization layer 112 (the number of nanowires 612 per unit area is the same over the entire surface of the second metallization layer 112), and each of the second plurality of nanowires 612 comprises a first end and a second end, wherein the first end of each of the second plurality nanowires 612 is inseparably connected to the surface of the second metallization layer 112. The second plurality of nanowires 612 may be used to form a permanent connection between the substrate 10 and a heat sink or base plate 80, for example.

As has been described above, forming nanowires 612 over a (large) section or over the entire surface area of the first metallization layer 111 allows using the substrate 10 very flexibly, as it is not limited to specific designs. The nanowires 612, however, provide further advantages. As has been described with respect to Figure 1 above, power semiconductor modules often comprise an encapsulant 5 configured to protect the components and electrical connections of the power semiconductor module, in particular the components arranged on the substrate 10 inside a housing, from certain environmental conditions and mechanical damage. A substrate arrangement comprising a substrate 10 with nanowires 612 formed thereon and an encapsulant 5 is schematically illustrated in Figure 9.

The encapsulant 5 is generally formed after the components 20, 4 have been mounted to the substrate 10. The encapsulant 5 is formed by filling a liquid or viscous material into a housing (not specifically illustrated in Figure 9) and by curing the originally liquid or viscous material, e.g., under the influence of heat and optionally pressure. When the liquid or viscous material of the encapsulant 5 is filled into a housing to cover the substrate 10, the material directly adjoins the free second ends of a second subset of the plurality of nanowires (the second subset including different nanowires 612 than the first subset) and also fills any gaps and spaces between the different ones of the plurality of nanowires 612 of the second subset. When curing the material, a connection is formed between the encapsulant 5 and the nanowires 612 of the second subset. That is, the encapsulant adheres to the nanowires 612 of the second subset, and therefore to the surface of the first metallization layer 111, without the need for any additional adhesion promoters.

## Claims

1. A substrate arrangement comprises,
a first metallization layer (111);
a plurality of nanowires (612) arranged on a surface of the first metallization layer (111); and
at least one component (20, 4) arranged on the first metallization layer (111) such that a first subset of the plurality of nanowires (612) is arranged between the first metallization layer (111) and the at least one component (20, 4), wherein
the plurality of nanowires (612) is evenly distributed over a section of the surface area or over the entire surface area of the first metallization layer (111),
each of the plurality of nanowires (612) comprises a first end and a second end, wherein the first end of each of the plurality nanowires (612) is inseparably connected to the surface of the first metallization layer (111),
the second end of each nanowire of the first subset is inseparably connected to a surface of one of the at least one component (20, 4) such that the first subset of nanowires (612) forms a permanent connection between the first metallization layer (111) and the at least one component (20, 4),
the at least one component (20, 4) comprises at least one semiconductor body (20),
the number of nanowires (612) comprised in the first subset of nanowires (612) is less than the number of nanowires (612) comprised in the plurality of nanowires (612), and
the substrate arrangement further comprises an encapsulant (5), wherein the encapsulant (5) consists of or includes a silicone gel and directly adjoins the second ends of a second subset of the plurality of nanowires (612) and fills any gaps and spaces between the nanowires of the second subset.

2. The substrate arrangement of claim 1, wherein the section of the surface area of the first metallization layer (111) covered by the plurality of nanowires (612) is between 60% and 100%, or between 70% and 100% of the entire surface area of the first metallization layer (111).

3. The substrate arrangement of claim 1 or 2, further comprising a dielectric insulation layer (11), wherein the first metallization layer (111) is attached to a first side of the dielectric insulation layer (11).

4. The substrate arrangement of claim 3, further comprising
a second metallization layer (112) attached to a second side of the dielectric insulation layer (11) opposite the first side; and
a second plurality of nanowires (612) arranged on a surface of the second metallization layer (112) that faces away from the dielectric insulation layer (11), wherein
the second plurality of nanowires (612) is evenly distributed over the entire surface of the second metallization layer (112), and
each of the second plurality of nanowires (612) comprises a first end and a second end, wherein the first end of each of the second plurality nanowires (612) is inseparably connected to the surface of the second metallization layer (112).

5. The substrate arrangement of any of claims 1 to 4, wherein the first metallization layer (111) is a structured layer comprising two or more separate sections, and recesses between different sections of the first metallization layer (111).

6. The substrate arrangement of any of claims 1 to 5, wherein each of the plurality of nanowires (612) has a diameter of between 500nm and 1200nm.

7. The substrate arrangement of any of claims 1 to 6, wherein all of the plurality of nanowires (612) have an equal length between their first end and their second end of between 10µm and 70µm.

8. The substrate arrangement of any of the preceding claims, wherein the first metallization layer (111) comprises or consists of copper, a copper alloy, aluminum, or an aluminum alloy.

9. The substrate arrangement of any of the preceding claims, wherein the plurality of nanowires (612) comprises or consists of carbon, cobalt, copper, silicon, or gold.

10. A method comprising:
forming a first metallization layer (111);
forming a plurality of nanowires (612) on a surface of the first metallization layer (111); and
arranging at least one component (20, 4) on the first metallization layer (111) such that a first subset of the plurality of nanowires (612) is arranged between the first metallization layer (111) and the at least one component (20, 4), wherein
the plurality of nanowires (612) is evenly distributed over a section of the surface area or over the entire surface area of the first metallization layer (111),
each of the plurality of nanowires (612) comprises a first end and a second end, wherein the first end of each of the plurality nanowires (612) is inseparably connected to the surface of the first metallization layer (111),
the second end of each nanowire of the first subset is inseparably connected to a surface of one of the at least one component (20, 4) such that the first subset of nanowires (612) forms a permanent connection between the first metallization layer (111) and the at least one component (20, 4),
the at least one component (20, 4) comprises at least one semiconductor body (20),
the number of nanowires (612) comprised in the first subset of nanowires (612) is less than the number of nanowires (612) comprised in the plurality of nanowires (612), and
the method further comprises forming an encapsulant (5), wherein the encapsulant (5) consists of or includes a silicone gel and directly adjoins the second ends of a second subset of the plurality of nanowires (612) and fills any gaps and spaces between the nanowires of the second subset.

11. The method of claim 10, further comprising
structuring the first metallization layer (111), thereby forming two or more separate sections and recesses between different sections of the first metallization layer (111).

12. The method of claim 11, wherein
the first metallization layer (111) is structured after forming the plurality of nanowires (612).

13. The method of claim 11, wherein
the first metallization layer (111) is structured before forming the plurality of nanowires (612).

14. The method of claim 13, further comprising
after structuring the first metallization layer (111) and before forming the plurality of nanowires (612), forming a masking layer (70) in the recesses between different sections of the first metallization layer (111).

## Patentansprüche

1. Substratanordnung, aufweisend:
eine erste Metallisierungsschicht (111);
eine Mehrzahl von Nanodrähten (612), die auf einer Oberfläche der ersten Metallisierungsschicht (111) angeordnet ist; und
mindestens eine Komponente (20, 4), die auf der ersten Metallisierungsschicht (111) angeordnet ist, sodass eine erste Teilmenge der Mehrzahl von Nanodrähten (612) zwischen der ersten Metallisierungsschicht (111) und der mindestens einen Komponente (20, 4) angeordnet ist, wobei
die Mehrzahl von Nanodrähten (612) gleichmäßig über einen Abschnitt des Oberflächenbereichs oder über den gesamten Oberflächenbereich der ersten Metallisierungsschicht (111) verteilt ist,
jeder der Mehrzahl von Nanodrähten (612) ein erstes Ende und ein zweites Ende umfasst, wobei das erste Ende jedes der Mehrzahl von Nanodrähten (612) untrennbar mit der Oberfläche der ersten Metallisierungsschicht (111) verbunden ist,
das zweite Ende jedes Nanodrahtes der ersten Teilmenge untrennbar mit einer Oberfläche einer der mindestens einen Komponente (20, 4) verbunden ist, sodass die erste Teilmenge von Nanodrähten (612) eine dauerhafte Verbindung zwischen der ersten Metallisierungsschicht (111) und der mindestens einen Komponente (20, 4) bildet,
die mindestens eine Komponente (20, 4) mindestens einen Hableiterkörper (20) umfasst,
die in der ersten Teilmenge von Nanodrähten (612) umfasste Anzahl von Nanodrähten (612) kleiner ist als die in der Mehrzahl von Nanodrähten (612) umfasste Anzahl von Nanodrähten (612), und
die Substratanordnung ferner ein Verkapselungsmaterial (5) umfasst, wobei das Verkapselungsmaterial (5) aus einem Silikongel besteht oder ein solches aufweist und direkt an die zweiten Enden einer zweiten Teilmenge der Mehrzahl von Nanodrähten (612) angrenzt und alle Lücken und Räume zwischen den Nanodrähten der zweiten Teilmenge füllt.

2. Substratanordnung nach Anspruch 1, wobei der von der Mehrzahl von Nanodrähten (612) bedeckte Abschnitt des Oberflächenbereichs der ersten Metallisierungsschicht (111) zwischen 60 % und 100 % oder zwischen 70 % und 100 % des gesamten Oberflächenbereichs der ersten Metallisierungsschicht (111) beträgt.

3. Substratanordnung nach Anspruch 1 oder 2, ferner aufweisend eine dielektrische Isolierschicht (11), wobei die Metallisierungsschicht (111) an einer Seite der dielektrischen Isolierschicht (11) angebracht ist.

4. Substratanordnung nach Anspruch 3, ferner aufweisend:
eine zweite Metallisierungsschicht (112), die an einer zweiten Seite der dielektrischen Isolierschicht (11) gegenüber der ersten Seite angebracht ist; und
eine zweite Mehrzahl von Nanodrähten (612), die auf einer Oberfläche der zweiten Metallisierungsschicht (112) angeordnet ist, die von der dielektrischen Isolierschicht (11) abgewandt ist, wobei
die zweite Mehrzahl von Nanodrähten (612) gleichmäßig über die gesamte Oberfläche der zweiten Metallisierungsschicht (112) verteilt ist, und
jeder der zweiten Mehrzahl von Nanodrähten (612) ein erstes Ende und ein zweites Ende umfasst, wobei das erste Ende jedes der zweiten Mehrzahl von Nanodrähten (612) untrennbar mit der Oberfläche der zweiten Metallisierungsschicht (112) verbunden ist.

5. Substratanordnung nach einem der Ansprüche 1 bis 4, wobei die erste Metallisierungsschicht (111) eine strukturierte Schicht ist, die zwei oder mehr separate Abschnitte und Aussparungen zwischen verschiedenen Abschnitten der ersten Metallisierungsschicht (111) aufweist.

6. Substratanordnung nach einem der Ansprüche 1 bis 5, wobei jeder der Mehrzahl von Nanodrähten (612) einen Durchmesser von zwischen 500 nm und 1200 nm aufweist.

7. Substratanordnung nach einem der Ansprüche 1 bis 6, wobei alle der Mehrzahl von Nanodrähten (612) eine gleiche Länge zwischen ihrem ersten Ende und ihrem zweiten Ende von zwischen 10 µm und 70 µm aufweisen.

8. Substratanordnung nach einem der vorhergehenden Ansprüche, wobei die erste Metallisierungsschicht (111) Kupfer, eine Kupferlegierung, Aluminium oder eine Aluminiumlegierung aufweist oder daraus besteht.

9. Substratanordnung nach einem der vorhergehenden Ansprüche, wobei Mehrzahl von Nanodrähten (612) Kohlenstoff, Kobalt, Kupfer, Silizium oder Gold aufweist oder daraus besteht.

10. Verfahren, aufweisend:
Bilden einer ersten Metallisierungsschicht (111);
Bilden einer Mehrzahl von Nanodrähten (612) auf einer Oberfläche der ersten Metallisierungsschicht (111); und
Anordnen mindestens einer Komponente (20, 4) auf der ersten Metallisierungsschicht (111), sodass eine erste Teilmenge der Mehrzahl von Nanodrähten (612) zwischen der ersten Metallisierungsschicht (111) und der mindestens einen Komponente (20, 4) angeordnet ist, wobei
die Mehrzahl von Nanodrähten (612) gleichmäßig über einen Abschnitt des Oberflächenbereichs oder über den gesamten Oberflächenbereich der ersten Metallisierungsschicht (111) verteilt ist,
jeder der Mehrzahl von Nanodrähten (612) ein erstes Ende und ein zweites Ende umfasst, wobei das erste Ende jedes der Mehrzahl von Nanodrähten (612) untrennbar mit der Oberfläche der ersten Metallisierungsschicht (111) verbunden ist,
das zweite Ende jedes Nanodrahtes der ersten Teilmenge untrennbar mit einer Oberfläche einer der mindestens einen Komponente (20, 4) verbunden ist, sodass die erste Teilmenge von Nanodrähten (612) eine dauerhafte Verbindung zwischen der ersten Metallisierungsschicht (111) und der mindestens einen Komponente (20, 4) bildet,
die mindestens eine Komponente (20, 4) mindestens einen Hableiterkörper (20) umfasst,
die in der ersten Teilmenge von Nanodrähten (612) umfasste Anzahl von Nanodrähten (612) kleiner ist als die in der Mehrzahl von Nanodrähten (612) umfasste Anzahl von Nanodrähten (612), und
das Verfahren ferner ein Bilden eines Verkapselungsmaterials (5) umfasst, wobei das Verkapselungsmaterial (5) aus einem Silikongel besteht oder ein solches aufweist und direkt an die zweiten Enden einer zweiten Teilmenge der Mehrzahl von Nanodrähten (612) angrenzt und alle Lücken und Räume zwischen den Nanodrähten der zweiten Teilmenge füllt.

11. Verfahren nach Anspruch 10, ferner aufweisend:
Strukturieren der ersten Metallisierungsschicht (111), um dadurch zwei oder mehr separate Abschnitte und Aussparungen zwischen verschiedenen Abschnitten der ersten Metallisierungsschicht (111) zu bilden.

12. Verfahren nach Anspruch 11, wobei
die erste Metallisierungsschicht (111) nach dem Bilden der Mehrzahl von Nanodrähten (612) strukturiert wird.

13. Verfahren nach Anspruch 11, wobei
die erste Metallisierungsschicht (111) vor dem Bilden der Mehrzahl von Nanodrähten (612) strukturiert wird.

14. Verfahren nach Anspruch 13, ferner aufweisend:
Bilden einer Maskierungsschicht (70) in den Aussparungen zwischen verschiedenen Abschnitten der Metallisierungsschicht (111) nach dem Strukturieren der ersten Metallisierungsschicht (111) und vor dem Bilden der Mehrzahl von Nanodrähten (612).

## Revendications

1. Un agencement d'un substrat comprend
une première couche (111) de métallisation ;
une pluralité de nanofils (612) disposée sur une surface de la première couche (111) de métallisation ; et
au moins un composant (20, 4) disposé sur la première couche (111) de métallisation, de manière à ce qu'un premier sous-ensemble de la pluralité de nanofils (612) soit disposé entre la première couche (111) de métallisation et le au moins un composant (20, 4), dans lequel
la pluralité de nanofils (612) est répartie uniformément sur une partie de la zone de surface ou sur toute la zone de surface de la première couche (111) de métallisation,
chacun de la pluralité de nanofils (612) comprend un premier bout et un deuxième bout, dans lequel le premier bout de chacun de la pluralité de nanofils (612) est connecté inséparablement à la surface de la première couche (111) de métallisation,
le deuxième bout de chaque nanofil du premier sous-ensemble est connecté inséparablement à une surface de l'un du au moins un composant (20, 4) de manière à ce que le premier sous-ensemble de nanofils (612) forme une connexion permanente entre la première couche (111) de métallisation et le au moins un composant (20, 4),
le au moins un composant (20, 4) comprend au moins un corps (20) semiconducteur,
le nombre de nanofils (612) compris dans le premier sous-ensemble de nanofils (612) est plus petit que le nombre de nanofils (612) compris dans la pluralité de nanofils (612), et
l'agencement d'un substrat comprend en outre un agent (5) d'enrobage, dans lequel l'agent (5) d'enrobage consiste en ou comprend un gel de silicone et est voisin directement des deuxièmes bouts d'un deuxième sous-ensemble de la pluralité de nanofils (612) et remplit tous les intervalles et espaces entre les nanofils du deuxième sous-ensemble.

2. L'agencement d'un substrat suivant la revendication 1, dans lequel la partie de la zone de surface de la première couche (111) de métallisation recouverte de la pluralité de nanofils (612) représente entre 60 % et 100 %, ou entre 70 % et 100 % de toute la zone de surface de la première couche (111) de métallisation.

3. L'agencement d'un substrat suivant la revendication 1 ou 2, comprenant en outre une couche (11) diélectrique isolante, dans lequel la première couche (111) de métallisation est fixée à une première face de la couche (11) diélectrique isolante.

4. L'agencement d'un substrat suivant la revendication 3, comprenant en outre
une deuxième couche (112) de métallisation fixée à une deuxième face de la couche (11) diélectrique isolante opposée à la première face ; et
une deuxième pluralité de nanofils (612) disposée sur une surface de la deuxième couche (112) de métallisation, qui fait face à la couche (11) diélectrique isolante en en étant éloignée, dans lequel
la deuxième pluralité de nanofils (612) est répartie uniformément sur toute la surface de la deuxième couche (112) de métallisation, et
chacun de la deuxième pluralité de nanofils (612) comprend un premier bout et un deuxième bout, dans lequel le premier bout de chacun de la deuxième pluralité de nanofils (612) est connecté inséparablement à la surface de la deuxième couche (112) de métallisation.

5. L'agencement d'un substrat suivant l'une quelconque des revendications 1 à 4, dans lequel la première couche (111) de métallisation est une couche structurée comprenant deux ou plusieurs parties distinctes et des cavités entre des parties différentes de la première couche (111) de métallisation.

6. L'agencement d'un substrat suivant l'une quelconque des revendications 1 à 5, dans lequel chacun de la pluralité de nanofils (612) a un diamètre compris entre 500 nm et 1200 nm.

7. L'agencement d'un substrat suivant l'une quelconque des revendications 1 à 6, dans lequel tous de la pluralité de nanofils (612) ont une longueur égale entre leur premier bout et leur deuxième bout comprise entre 10 µm et 70 µm.

8. L'agencement d'un substrat suivant l'une quelconque des revendications précédentes, dans lequel la première couche (111) de métallisation comprend ou consiste en du cuivre, un alliage de cuivre, de l'aluminium ou un alliage d'aluminium.

9. L'agencement d'un substrat suivant l'une quelconque des revendications précédentes, dans lequel la pluralité de nanofils (612) comprend ou consiste en du carbone, du cobalt, du cuivre, du silicium ou de l'or.

10. Procédé comprenant :
former une première couche (111) de métallisation ;
former une pluralité de nanofils (612) sur une surface de la première (111) de métallisation ; et
mettre au moins un composant (20, 4) sur la première couche (111) de métallisation, de manière à ce qu'un premier sous-ensemble de la pluralité de nanofils (612) soit disposé entre la première couche (111) de métallisation et le au moins un composant (20, 4), dans lequel
la pluralité de nanofils (612) est répartie uniformément sur une partie de la zone de surface ou sur toute la zone de surface de la première couche (111) de métallisation,
chacun de la pluralité de nanofils (612) comprend un premier bout et un deuxième bout, dans lequel le premier bout de chacun de la pluralité de nanofils (612) est connecté inséparablement à la surface de la première couche (111) de métallisation,
le deuxième bout de chaque nanofil du premier sous-ensemble est connecté inséparablement à une surface de l'un du au moins un composant (20, 4), de manière à ce que le premier sous-ensemble de nanofils (612) forme une connexion permanente entre la première couche (111) de métallisation et le au moins un composant (20, 4),
le au moins un composant (20, 4) comprend au moins un corps (20) semiconducteur,
le nombre de nanofils (612) compris dans le premier sous-ensemble de nanofils (612) est plus petit que le nombre de nanofils (612) compris dans la pluralité de nanofils (612), et
le procédé comprend en outre former un agent (5) d'enrobage, dans lequel l'agent (5) d'enrobage consiste ou comprend un gel de silicone et est voisin directement des deuxièmes bouts d'un deuxième sous-ensemble de la pluralité de nanofils (612) et remplit tous les intervalles et espaces entre les nanofils du deuxième sous-ensemble.

11. Procédé suivant la revendication 10, comprenant en outre :
structurer la première couche (111) de métallisation, en formant ainsi deux ou plusieurs parties distinctes et cavités entre les parties différentes de la première couche (111) de métallisation.

12. Procédé suivant la revendication 11, dans lequel
on structure la première couche (111) de métallisation après avoir formé la pluralité de nanofils (612).

13. Procédé suivant la revendication 11, dans lequel
on structure la première couche (111) de métallisation avant de former la pluralité de nanofils (612).

14. Procédé suivant la revendication 13, comprenant en outre
après avoir structuré la première couche (111) de métallisation et avant de former la pluralité de nanofils (612), on forme une couche (70) de masquage dans les cavités entre des partie différentes de la première couche (111) de métallisation.
